# EUROPÄISCHE PATENTANMELDUNG

(11) **EP 2 110 904 A1**
(43) Veröffentlichungstag der Anmeldung: **21.10.2009**
(21) Anmeldenummer: 09156692.7
(22) Anmeldetag: 30.03.2009
(51) Int. Cl.: H01S 5/028, H01S 5/125, H01L 33/00

(54) **Optoelektronisches Halbleiterbauelement und Verfahren zur Herstellung eines optoelektronischen Halbleiterbauelements**

(30) Priorität: 15.04.2008 DE 102008018928
(71) Anmelder: OSRAM Opto Semiconductors GmbH, 93055 Regensburg (DE)
(72) Erfinder: Kaiser, Stephan, 93049 Regensburg (DE); Mayer, Bernd, 93059 Regensburg (DE); Hahn, Berthold, 93155 Hemau (DE); Eberhard, Franz, 93059 Regensburg (DE)
(74) Vertreter: Epping - Hermann - Fischer

(57) **Zusammenfassung**

In mindestens einer Ausführungsform des optoelektronischen Halbleiterbauelements (1) umfasst dieses mindestens einen optisch aktiven Bereich (2), der mit einem kristallinen Halbleitermaterial gebildet ist, das mindestens einen der Stoffe Gallium oder Aluminium enthält. Weiterhin umfasst das Halbleiterbauelement mindestens eine Facette (3) am optisch aktiven Bereich. Weiterhin weist das Halbleiterbauelement mindestens eine schwefel- oder selenhaltige Grenzschicht (4) mit einer Dicke von bis zu fünf Monolagen auf, wobei die Grenzschicht sich an der Facette befindet. Ein solches Halbleiterbauelement hat eine hohe Zerstörschwelle bezüglich optischer Leistungen, die im Betrieb des Halbleiterelements auftreten.

## Beschreibung

Es wird ein optoelektronisches Halbleiterbauelement angegeben. Darüber hinaus wird ein Verfahren zur Herstellung eines solchen optoelektronischen Halbleiterbauelements angegeben.

Optoelektronische Halbleiterbauelemente, wie beispielsweise Halbleiterlaser, finden sich auf vielen technischen Anwendungsgebieten wieder. Optoelektronische Halbleiterbauelemente können durch Eigenschaften wie kompakte Bauweise, geringer Platzbedarf, vielfältige Ausgestaltungsmöglichkeiten, gute Effizienz und hoher Wirkungsgrad sowie gute Einstellmöglichkeit des relevanten Spektralbereichs überzeugen. Für viele Anwendungsbereiche sind optoelektronische Halbleiterbauelemente erwünscht, die leuchtkräftig sind, hohe Intensitäten und große optische Ausgangsleistungen aufweisen.

In der Druckschrift EP 1 514 335 B1 ist ein Verfahren zur Passivierung der Spiegelflächen von optischen Halbleiterbauelementen beschrieben.

In der Druckschrift US 5,799,028 ist eine Passivierung und ein Schutz einer Halbleiteroberfläche offenbart.

Eine zu lösende Aufgabe besteht darin, ein optoelektronisches Halbleiterbauelement anzugeben, das für hohe optische Ausgangsleistungen geeignet ist. Eine weitere zu lösende Aufgabe besteht darin, ein effizientes und einfaches Verfahren zur Herstellung eines solchen optoelektronischen Halbleiterbauelements anzugeben.

Gemäß zumindest einer Ausführungsform des optoelektronischen Halbleiterbauelements umfasst dieses mindestens einen optisch aktiven Bereich. Der optisch aktive Bereich besteht mindestens zum Teil aus einem kristallinen Halbleitermaterial. Mindestens einer der Stoffe Gallium oder Aluminium wird von dem den optisch aktiven Bereich bildenden Halbleitermaterial umfasst. Beispielsweise weist der optisch aktive Bereich eine pn-Übergangszone auf. Der optisch aktive Bereich kann quantentopf-, quantenpunkt- oder quantenlinienartige Strukturen, entweder einzeln oder in Kombination, oder auch flächig ausgestaltete pn-Übergangsbereiche enthalten. Mögliche Bauteile, in denen der optisch aktive Bereich eingesetzt werden kann, sind etwa Laserdioden, insbesondere für nahinfrarotes Licht, Superlumineszenzdioden oder Leuchtdioden, insbesondere Hochleistungsdioden, das heißt, Dioden mit einer optischen Leistung von mindestens 0,5 W, bevorzugt von solchen mit einer optischen Leistung von mindestens 1 W.

Gemäß zumindest einer Ausführungsform des optoelektronischen Halbleiterbauelements weist dieses mindestens eine Facette am optisch aktiven Bereich auf. Das Halbleiterbauelement kann insbesondere über zwei Facetten an einander gegenüberliegenden Seiten verfügen. Unter Facette ist hierbei eine glatte Grenzfläche zu verstehen. "Glatt" bedeutet hierbei, dass die Oberflächenrauheit der Facette deutlich kleiner ist als die Wellenlänge des vom optoelektronischen Halbleiterbauteils 1 in dessen Betrieb zu erzeugenden Lichts, bevorzugt kleiner als die Hälfte der Wellenlänge, besonders bevorzugt kleiner als ein Viertel der Wellenlänge. Die Facette bildet also eine Grenzfläche oder eine Außenfläche des optisch aktiven Bereichs aus, etwa zwischen diesem und umgebender Luft oder einem anderen Material mit niedrigerem optischen Brechungsindex, als der optisch aktive Bereich aufweist. Die Facette kann eine angeschliffene Fläche darstellen. Eine Facette am optisch aktiven Bereich kann auch erzeugt werden, indem dessen Halbleitermaterial beispielsweise eingeritzt und anschließend gebrochen wird.

Gemäß zumindest einer Ausführungsform des optoelektronischen Halbleiterbauelements umfasst dieses mindestens eine schwefel- oder selenhaltige Grenzschicht. Diese befindet sich an der Facette. Bevorzugt steht die Grenzschicht in direktem Kontakt zur Facette. Die Grenzschicht bedeckt mindestens einen Teil der von der Facette gebildeten Grenzfläche, bevorzugt die gesamte Grenzfläche. Die Dicke der Grenzschicht beträgt höchstens zehn Monolagen, bevorzugt höchstens fünf Monolagen. Besonders bevorzugt beträgt die Dicke der Grenzschicht höchstens eine Monolage. Als Monolage wird hierbei eine Kristallschicht der Dicke einer Einheitszelle des Halbleitermaterials aufgefasst. In der Grenzschicht sind bevorzugt keine Sauerstoffatome vorhanden. Das heißt, die Grenzschicht ist frei von Sauerstoffatomen, wobei "frei" bedeutet, dass der Sauerstoffrestanteil weniger als 10 Teile pro Milliarde, kurz ppb, beträgt, besonders bevorzugt weniger als 1 ppb.

In mindestens einer Ausführungsform des optoelektronischen Halbleiterbauelements umfasst dieses mindestens einen optisch aktiven Bereich, der mit einem kristallinen Halbleitermaterial gebildet ist, das mindestens einen der Stoffe Gallium oder Aluminium enthält. Weiterhin umfasst das Halbleiterbauelement mindestens eine Facette am optisch aktiven Bereich. Weiterhin weist das Halbleiterbauelement mindestens eine schwefel- oder selenhaltige Grenzschicht mit einer Dicke von bis zu fünf Monolagen auf, wobei die Grenzschicht sich an der Facette befindet. Ein solches Halbleiterbauelement hat eine hohe Zerstörschwelle bezüglich optischer Leistungen, die im Betrieb des Halbleiterelements auftreten.

Sind Halbleitermaterialien, die mindestens einen der Stoffe Aluminium oder Gallium enthalten, etwa Luft, insbesondere Sauerstoff, ausgesetzt, so findet eine Oxidation statt. An der Grenzfläche Halbleitermaterial/Luft bildet sich infolgedessen eine Oxidschicht. Diese Oxidschicht und eventuelle weitere Verunreinigungen können Farbbeziehungsweise Absorptionszentren ausbilden, die im Betrieb des optoelektronischen Halbleiterbauteils verstärkt Licht absorbieren beziehungsweise reabsorbieren. Dies führt zu einer lokalen Erwärmung im Bereich der Verunreinigungen beziehungsweise der oxidierten Bereiche. Je nach verwendetem Halbleitermaterial kann diese lokale Erwärmung wiederum zu einer Absenkung der Bandlücke des Halbleitermaterials führen, was die Reabsorption verstärkt. Die Temperatur im Bereich der Verunreinigungen steigt dadurch weiter an.

Die lokale Erhitzung aufgrund von Absorption beziehungsweise Reabsorption kann bis zu einem Aufschmelzen der betroffenen Halbleiterbereiche führen und dadurch die Grenzfläche, insbesondere die Facette, zerstören. Die Effizienz des betroffenen optoelektronischen Halbleiterbauteils wird hierdurch negativ beeinflusst. Ist auf der Facette beispielsweise eine Spiegelschicht aufgetragen, so kann ebenfalls die Spiegelschicht beschädigt werden. Speziell kann die Spiegelschicht aufgrund eines lokalen Aufschmelzens sich von der Facette lösen. Insbesondere im Falle eines Laserresonators, bei dem die Facette und eine daran angebrachte Spiegelschicht mindestens einen Resonatorspiegel ausbilden, kann dies zu einer Zerstörung des zum Beispiel als Laserdiode ausgestalteten Bauteils führen. Dies wird auch als katastrophaler optischer Schaden, Catastrophical Optical Damage, kurz COD, bezeichnet. Die Intensitätsbeziehungsweise Lichtleistungsschwelle, ab der der Degradationsmechanismus einsetzt, ist ein Gütekriterium, beispielsweise für einen Laser, und wird als Power Catastrophical Optical Damage-Schwelle, kurz PCOD-Schwelle, bezeichnet.

Dieser Zerstörungsmechanismus kann unterbunden oder zu deutlich höheren optischen Leistungen hin verschoben werden, indem verhindert wird, dass die Facette ganz oder teilweise oxidiert. Die Oxidation kann unterbunden werden, indem an der Facette eine Grenzschicht angebracht ist, die an potentiellen Sauerstoff-Anbindungsstellen Atome mit einer größeren Affinität zum Halbleitermaterial des optisch aktiven Bereichs aufweist als Sauerstoff selbst. Dies wird durch eine schwefel- oder selenhaltige Grenzschicht erreicht. Zudem ist die schwefel- oder selenhaltige Grenzschicht für die relevante, beispielsweise nahinfrarote Laserstrahlung transparent, sodass keine Absorption beziehungsweise Reabsorption an der Grenzschicht auftritt.

Gemäß zumindest einer Ausführungsform des optoelektronischen Halbleiterbauelements umfasst dieses mindestens eine Passivierungsschicht auf der Grenzschicht. Die Passivierungsschicht deckt mindestens Teile der Grenzschicht und somit auch der Facette ab. Bevorzugt bedeckt die Passivierungsschicht die komplette Grenzschicht und ebenfalls die komplette durch die Facette gebildete Grenzfläche. Mehrere verschieden ausgeprägte, aufeinander angeordnete Passivierungsschichten können etwa als Adapterschichten zwischen Facette und weiteren, aufzubringenden Schichten dienen, zum Beispiel, um eine Anpassung verschiedener Kristallgitter aneinander zu ermöglichen. Ein solches Halbleiterbauelement kann vielseitig ausgestaltet sein und ist robust gegen Umwelteinflüsse wie beispielsweise Oxidation und Feuchtigkeit.

Gemäß zumindest einer Ausführungsform des optoelektronischen Halbleiterbauelements basiert das Halbleitermaterial des optisch aktiven Bereichs auf Galliumarsenid, Aluminium-Gallium-Arsenid, Indium-Gallium-Aluminium-Phosphid, Gallium-Indium-Nitrid-Arsenid, Galliumnitrid, Indium-Gallium-Aluminium-Arsenid oder Galliumphosphid. "Basierend auf" bedeutet hierbei, dass der wesentliche Bestandteil des Halbleitermaterials einer der genannten Verbindungen entspricht. Das Halbleitermaterial kann auch andere, insbesondere Dotierstoffe aufweisen. Durch die Verwendung derartiger Halbleitermaterialien kann der vom optisch aktiven Bereich zu emittierende oder zu empfangende Frequenzbereich abgestimmt werden.

Gemäß zumindest einer Ausführungsform des optoelektronischen Halbleiterbauelements weist die Grenzschicht Galliumselenid, Galliumsulfid, Aluminiumselenid oder Aluminiumsulfid auf. Selen und Schwefel weisen eine hohe chemische Affinität zu Gallium beziehungsweise Aluminium auf. Die Affinität von Selen und Schwefel zu Gallium und Aluminium kann insbesondere höher sein als die von Sauerstoff zu Gallium und Aluminium. Dadurch verhindert eine solche Grenzschicht schädigenden Einfluss auf die Facette durch Oxidation.

Gemäß zumindest einer Ausführungsform des optoelektronischen Halbleiterbauelements ist die Passivierungsschicht mit Zinkselenid oder Zinksulfid gestaltet. Eine solche Passivierungsschicht kann einfach zum Beispiel über metallorganische Gasphasenepitaxie, kurz MOVPE, hergestellt werden und bietet guten Schutz, beispielsweise gegen Oxidation oder Feuchtigkeit.

Gemäß zumindest einer Ausführungsform des optoelektronischen Halbleiterbauelements beträgt die Dicke der Passivierungsschicht wenigstens 5 nm und höchstens 200 nm, bevorzugt wenigstens 10 nm und höchstens 100 nm, besonders bevorzugt wenigstens 20 nm und höchstens 60 nm. Eine Passivierungsschicht einer derartig gestalteten Dicke ist mit angemessenem Fertigungsaufwand herzustellen und bietet einen ausreichenden Schutz des Halbleiterbauelements, insbesondere des optisch aktiven Bereichs, speziell vor Oxidation.

Gemäß zumindest einer Ausführungsform des optoelektronischen Halbleiterbauelements umfasst dieses mindestens eine dielektrische Schichtenfolge, die in Form eines Bragg-Spiegels auf der Passivierungsschicht aufgebracht ist. Ein Bragg-Spiegel wird aus einer Anzahl dielektrischer Schichten mit abwechselnd hohem und niedrigem optischen Brechungsindex gebildet. Die Anzahl der Schichten beträgt bevorzugt zwischen zehn und zwanzig. Die einzelnen dielektrischen Schichten können beispielsweise aus Aluminiumoxid, Siliziumdioxid, Tantaloxid, Silizium-Aluminium-Galliumarsenid oder Aluminium-Gallium-Indium-Phosphid basieren, je nachdem, für welchen Spektralbereich der Bragg-Spiegel reflektierend wirken soll. Der Bragg-Spiegel bedeckt mindestens einen Teil der Passivierungsschicht, bevorzugt die gesamte Passivierungsschicht und somit auch die gesamte Facette. Über einen Bragg-Spiegel ist auf einfache Art und Weise ein Resonator hoher Güte, beispielsweise für ein Laserbauteil, erzeugbar.

Gemäß zumindest einer Ausführungsform des optoelektronischen Halbleiterbauelements ist dieses als Laserbarren ausgestaltet. Das bedeutet, das optoelektronische Halbleiterbauelement weist einen zum Beispiel elektrisch oder optisch pumpbaren optisch aktiven Bereich auf. Außerdem umfasst das Halbleiterbauelement einen Laserresonator, der beispielsweise durch Facetten beziehungsweise Grenzflächen am optisch aktiven Bereich gebildet wird. Bevorzugt weist der Laserbarren ebenfalls elektrische Anschlusseinrichtungen auf, um den Laserbarren, falls dieser elektrisch gepumpt wird, betreiben zu können. Ein derart gestalteter Laserbarren weist eine hohe Zerstörschwelle auf und ist dazu geeignet, hohe optische Ausgangsleistungen zu erzeugen.

Es wird darüber hinaus ein Verfahren zur Herstellung eines optoelektronischen Halbleiterbauelements angegeben. Beispielsweise kann mittels des Verfahrens ein optoelektronisches Halbleiterbauelement hergestellt werden, wie es in Verbindung mit einem oder mehrerer der oben genannten Ausführungsformen beschrieben ist.

Das Verfahren zur Herstellung eines optoelektronischen Halbleiterbauelements weist gemäß zumindest einer Ausführungsform mindestens folgende Verfahrensschritte auf:
- Bereitstellen eines optisch aktiven Bereichs, dessen Halbleitermaterial mindestens einen der Stoffe Gallium oder Aluminium enthält,
- Erzeugen mindestens einer Facette am optisch aktiven Bereich,
- Desoxidation der Facette mittels eines schwefel- oder selenhaltigen Gasstroms, und
- Erzeugen mindestens einer selen- oder schwefelhaltigen Grenzschicht aus bis zu zehn Monolagen.

Durch ein derart gestaltetes Verfahren lässt sich ein optoelektronisches Halbleiterbauelement effizient und vergleichsweise einfach herstellen.

Das Bereitstellen des optisch aktiven Bereichs kann beinhalten, dass der aktive Bereich epitaktisch auf einem Aufwachssubstrat gewachsen wird. In diesem Falle kann das Aufwachsen des optisch aktiven Bereichs im Wafer-Verbund stattfinden. Der Verfahrensschritt des Bereitstellens kann ebenso enthalten, dass der optisch aktive Bereich von einem Aufwachssubstrat separiert wird oder dass ein Aufwachssubstrat, etwa ein Wafer, in mehrere Bestandteile, die ein oder mehrere optisch aktive Bereiche umfassen können, separiert wird.

Das Erzeugen der mindestens einen Facette am optisch aktiven Bereich kann mittels Ritzen und anschließendem Brechen oder auch mittels Spalten erfolgen. Die durch die Facette gebildete Grenzfläche des optisch aktiven Bereichs weist bevorzugt eine Rauheit auf, die geringer ist als die Wellenlänge der elektromagnetischen Strahlung, die vom optoelektronischen Halbleiterbauelement in dessen Betrieb erzeugt werden soll. Bevorzugt ist die Rauheit geringer als die Hälfte der Wellenlänge, besonders bevorzugt geringer als ein Viertel der Wellenlänge. Eine etwa gesägte Facette kann anschließend mittels Polieren oder Schleifen geglättet werden. Bevorzugt werden zwei einander im Wesentlichen gegenüberliegende beziehungsweise planparallel zueinander angeordnete Facetten gebildet, insbesondere wenn eine Verwendung des optoelektronischen Halbleiterbauelements für Laseranwendungen vorgesehen ist, so dass der optisch aktive Bereich zusammen mit den Facetten einen Resonator ausbilden soll. "Im Wesentlichen" bedeutet hierbei im Rahmen der Fertigungstoleranzen.

Bevorzugt wird die Desoxidation mit einem schwefel- oder selenhaltigen Gasstrom durchgeführt. Das Gas wird hierbei über die Facette geleitet, zum Beispiel ähnlich einem MOVPE-Verfahren. An der Grenzfläche des den optisch aktiven Bereich bildenden Halbleitermaterials werden hierdurch die sich an und nahe der Grenzfläche befindlichen Sauerstoffatome durch reaktive Selen- oder Schwefelatome aus dem Gasstrom ersetzt, wodurch die Desoxidation der Facette realisiert wird.

Eine selen- oder schwefelhaltige erzeugte Grenzschicht weist eine Dicke von höchstens fünf Monolagen auf, das heißt, die Dicke der Grenzschicht beträgt höchstens fünf Einheitszellen des Kristallgitters des Halbleitermaterials. Bevorzugt wird nur eine einzige Monolage ausgebildet. Die Dicke der Grenzschicht entspricht bevorzugt mindestens der Dicke der zu desoxidierenden, sauerstoffhaltigen Schicht. Die Monolage weist bevorzugt mindestens eine der Verbindungen Galliumselenid, Galliumsulfid, Aluminiumselenid oder Aluminiumsulfid auf.

Gemäß zumindest einer Ausführungsform des Verfahrens wird eine Passivierungsschicht mittels eines Gasstroms auf der Grenzschicht gebildet, etwa ähnlich einem MOVPE-Verfahren. Bevorzugt bedeckt die Passivierungsschicht die gesamte Grenzschicht, die wiederum bevorzugt die gesamte durch die Facette gebildete Grenzfläche bedeckt. Die Passivierungsschicht wird etwa durch ein II-VI-Halbleitermaterial, bevorzugt durch Zinkselenid oder Zinksulfid, gebildet. Das die Passivierungsschicht bildende Material wird bevorzugt so gewählt, dass es sich gut auf der Grenzschicht aufwachsen lässt. Beinhaltet die Grenzschicht zum Beispiel Ga(Al)₂Se₃, so stellt ZnSe ein besonders geeignetes Material für die Passivierungsschicht dar. Ein solches Verfahren ermöglicht eine einfache Herstellung eines Passivierungsfilms.

Gemäß zumindest einer Ausführungsform des Verfahrens finden die Verfahrensschritte Desoxidation und Erzeugen der Grenzschicht bei Atmosphärendrücken größer als 10⁻³ mbar statt. Das bedeutet, für diese Verfahrensschritte ist dann kein Hochvakuum oder Ultrahochvakuum erforderlich. Bei der Desoxidation mittels eines Gasstroms und gegebenenfalls beim Erzeugen einer Passivierungsschicht mittels eines Gasstroms treten bevorzugt Atmosphärendrücke im Bereich von 100 mbar bis 1100 mbar auf, besonders bevorzugt zwischen 300 mbar und 700 mbar. Da auf ein Hochvakuum oder Ultrahochvakuum verzichtet werden kann, reduzieren sich die Herstellungskosten des optoelektronischen Halbleiterbauteils.

Gemäß zumindest einer Ausführungsform des Verfahrens finden Desoxidation und Aufbringen der Passivierungsschicht in derselben Verfahrensführungskammer statt. Dies kann dadurch realisiert werden, dass der zu behandelnde optisch aktive Bereich in eine Kammer gebracht wird, in der eine Beströmung mit verschiedenen Gasen möglich ist. Zum Beispiel wird ein erster Gasstrom mit einem schwefel- oder selenhaltigen Gas über die Facette geleitet. Anschließend wird von diesem ersten Gasstrom auf einen zweiten Gasstrom umgeschaltet, wodurch die Passivierungsschicht aufgewachsen wird. Das Umschalten wird bevorzugt schnell vollzogen, so dass kein sauerstoffhaltiges Gas zur Facette gelangt. "Schnell" bedeutet hierbei insbesondere in weniger als einer Sekunde. Zwischen Desoxidation und Aufbringen der Passivierungsschicht muss das zu behandelnde Bauteil also nicht aus der Verfahrensführungskammer herausgeholt werden. Dies verhindert effektiv, dass zwischen Desoxidation und Aufbringen der Passivierungsschicht etwa eine Oxidation stattfinden kann. Außerdem vereinfacht sich das Verfahren, da ein Verfahrensschritt des Umlagerns der zu behandelnden Bauteile entfällt.

Gemäß zumindest einer Ausführungsform des Verfahrens zur Herstellung eines optoelektronischen Bauteils werden bei der Desoxidation beziehungsweise beim Aufbringen der Passivierungsschicht ein Gasstrom verwendet, der mindestens einen der Stoffe H₂, H₂Se, H₂S, ein Selen-Metall-Organyl, ein Schwefel-Metall-Organyl, Trimethylzink, Diethylzink oder ein Zinkorganyl enthalten. Der Gasstrom kann insbesondere Mischungen oben genannter Stoffe aufweisen. Auch Zusatzstoffe können dem Gasstrom beigegeben sein, beispielsweise um eine Dotierung zu erzielen. Durch die Verwendung oben aufgeführter Stoffe im Gasstrom wird ein effektives Desoxidieren und/oder Bilden der Passivierungsschicht ermöglicht.

Gemäß zumindest einer Ausführungsform des Verfahrens beträgt die Verfahrenstemperatur jeweils höchstens 360° C, insbesondere bei den Schritten Desoxidation, Erzeugen der Grenzschicht und Erzeugen der Passivierungsschicht. Bevorzugt liegt die Verfahrenstemperatur unterhalb von 350° C, besonders bevorzugt im Bereich zwischen 260 und 300° C.

Derartige Verfahrenstemperaturen können gewährleisten, dass der optisch aktive Bereich während des Herstellungsverfahrens aufgrund der Prozesstemperaturen nicht beschädigt wird.

Insbesondere bei solchen Prozesstemperaturen liegt das reaktive Gas nicht als hoch- oder niederenergetisches Plasma vor. Da kein Plasma vorliegt, kann die Behandlung des den optisch aktiven Bereich bildenden Halbleitermaterials und deren Facette besonders schonend erfolgen.

Gemäß zumindest einer Ausführungsform des Verfahrens beträgt die Dauer der Verfahrensschritte Desoxidation, Erzeugen der Grenzschicht und/oder Aufbringen der Passivierungsschicht jeweils weniger als sechs Minuten, bevorzugt weniger als drei Minuten, besonders bevorzugt weniger als eine Minute. Durch die geringe Zeitdauer der entsprechenden Verfahrensschritte wird eine kostengünstige Herstellung des optoelektronischen Halbleiterbauteils gewährleistet.

Gemäß zumindest einer Ausführungsform des Verfahrens sind die zu behandelnden Bauelemente während der Verfahrensschritte Desoxidation und/oder Aufbringen der Passivierungsschicht eingehordet. "Eingehordet" bedeutet hierbei, dass eine Vielzahl zu behandelnder Bauelemente, etwa in einem regelmäßigen Muster, auf einem Träger platziert sind. Als Träger können etwa Teller, Gitter oder Wafer verwendet werden. Der Träger samt den darauf befindlichen zu behandelnden Bauelementen wird dann in beispielsweise eine Verfahrensführungskammer eingeführt. Die zu behandelnden Facetten sind bevorzugt in einer Ebene angeordnet, die durch die Facetten gebildeten Grenzflächen der optisch aktiven Bereiche sind bevorzugt in eine gleiche Richtung ausgerichtet. Die zu behandelnden Bauteile können derart eingehordet sein, dass sich deren nicht durch Facetten gebildete Grenzflächen gegenseitig mindestens zum Teil berühren und abdecken, und somit nicht desoxidiert oder passiviert werden. Bevorzugt sind die zu behandelnden Bauteile quaderförmig ausgestaltet und die zu behandelnden Facetten sind durch Stirnflächen der Quader gebildet. Durch das Einhorden der zu behandelnden Bauteile ist ein effizientes und kostengünstiges Verfahren möglich.

Die angegebene Reihenfolge der Verfahrensschritte ist als bevorzugt anzusehen. Abweichende Reihenfolgen, je nach Erfordernissen, sind aber ebenso möglich.

Im Folgenden wird das hier beschriebene optoelektronische Halbleiterbauteil sowie das Verfahren zur Herstellung eines Halbleiterbauteils anhand von Ausführungsbeispielen und den dazugehörigen Figuren näher erläutert.

### Es zeigen:

- Figur 1: eine schematische Seitenansicht eines Ausführungsbeispiels eines optoelektronischen Halbleiterbauelements,
- Figur 2: eine schematische Seitenansicht eines weiteren Ausführungsbeispiels eines Halbleiterbauelements,
- Figur 3: eine schematische Seitenansicht eines Ausführungsbeispiels eines Halbleiterbauelements (a) in Form eines Laserbarrens sowie eine schematische Seitenansicht (b) eines Laserstapels,
- Figur 4: eine schematische Seitenansicht eines weiteren Ausführungsbeispiels eines Halbleiterbauelements in Form eines vertikal emittierenden Lasers,
- Figur 5: eine schematische dreidimensionale Darstellung von eingehordeten Bauelementen, und
- Figur 6: a bis f eine schematische Darstellung verschiedener Verfahrensschritte zur Herstellung eines optoelektronischen Halbleiterbauelements.

In den Ausführungsbeispielen und Figuren sind gleiche oder gleich wirkende Bestandteile jeweils mit den gleichen Bezugszeichen versehen. Die dargestellten Elemente sind nicht als maßstabsgetreu anzusehen; vielmehr können einzelne Elemente zum besseren Verständnis übertrieben groß dargestellt sein.

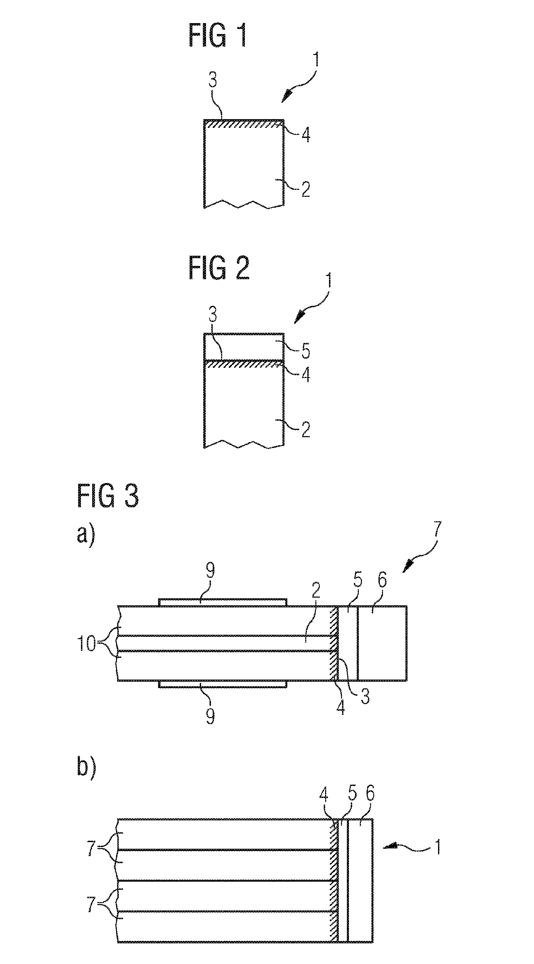

In Figur 1 ist ein Ausführungsbeispiel eines optoelektronischen Halbleiterbauelements 1 gezeigt. Am optisch aktiven Bereich 2, der etwa auf AlGaAs basiert, ist eine Facette 3 erzeugt. Die Facette 3 stellt eine glatte Grenzfläche am optisch aktiven Bereich 2 zur Umgebung dar. Über die gesamte Fläche der Facette 3 ist eine Grenzschicht 4 angebracht. Die Grenzschicht wird von einer Monolage Ga(Al)₂Se₃ gebildet. Diese Monolage weist die Dicke einer Einheitszelle des Kristallgitters auf. Aufgrund der hohen Affinität von Selen zu Gallium und Aluminium wird eine Oxidation der Facette unterbunden.

Beim Ausführungsbeispiel gemäß Figur 2 ist auf der Grenzschicht 4 zusätzlich eine Passivierungsschicht 5 aufgebracht. Das Halbleitermaterial des optisch aktiven Bereichs 2 basiert zum Beispiel auf InGaAlP. Die Grenzschicht 4 ist schwefelhaltig. Die Passivierungsschicht 5 weist eine Dicke von zirka 50 nm auf und besteht aus ZnS. Das in der Grenzschicht 4 vorhandene Ga(Al)₂S₃ bietet für ZnS eine gute Wachstumsbasis. Durch die geringe Dicke der Passivierungsschicht 5 führen Gitterfehlanpassungen zwischen Grenzschicht 4 und Passivierungsschicht 5 zwar möglicherweise zu Versetzungen im Kristallgitter, allerdings zu keinen Korngrenzen, so dass die Passivierungsschicht 5 dicht zum Beispiel gegenüber Sauerstoff ist. Die Passivierungsschicht 5 erfüllt also die Funktion, die an sauerstoffhaltiger Atmosphäre, insbesondere Luft, unbeständige Grenzschicht 4 vor der Einwirkung von Luft beziehungsweise vor Oxidation zu schützen.

Alternativ kann die Grenzschicht 4 auch mit Ga(Al)₂Se₃ gebildet sein, die Passivierungsschicht 5 besteht dann bevorzugt aus ZnSe. Neben ZnS und ZnSe werden geeignete Passivierungsschichten 5 beispielsweise von II-VI-Halbleitern wie CdSe, CdS, CdTe, ZnTe und BeTe, oder auch von MgTe oder MgSe gebildet.

Die Passivierungsschicht 5 besteht bevorzugt aus einem Material, das für die im Betrieb des optoelektronischen Halbleiterbauelements auftretenden Wellenlängen transparent ist. ZnSe ist transparent bei Wellenlängen größer als zirka 550 nm, ZnS bei Wellenlängen größer als zirka 370 nm, abhängig von der Kristallstruktur. Ebenso sind die Materialen der Grenzschicht 4 und der Passivierungsschicht 5 geeignet aufeinander abzustimmen, zum Beispiel betreffs der Gitterkonstanten der Kristallgitter.

Eine alternative oder zusätzliche Möglichkeit, eine Facette 3 vor einer Zerstörung aufgrund Absorption oder Reabsorption zu bewahren, besteht darin, die Strahlung erzeugenden oder absorbierenden Strukturen in einem optisch aktiven Bereich 2 in der Nähe der Facette 3 zu zerstören. Dies ist durch Auflösen von zum Beispiel Quantentöpfen im optisch aktiven Bereich 2, so genanntes Quantumwell-Intermixing, kurz QWI, möglich. Hierbei werden zum Beispiel Fremdmaterialien etwa durch Diffusion in die Kristallstruktur der sich nahe der Facette 3 befindlichen Regionen des optisch aktiven Bereichs 2 gebracht, wodurch dieser deaktiviert wird.

Ein Ausführungsbeispiel in Form eines Laserbarrens 7 ist in Figur 3a dargestellt. Ein optisch aktiver Bereich 2 ist von Halbleiterschichten 10 eingeschlossen, an denen wiederum Elektroden 9 zur Bestromung angebracht sind. Der optisch aktive Bereich 2 basiert zum Beispiel auf AlGaN. An der Facette 3, die durch Brechen erzeugt werden kann, befindet sich eine Grenzschicht 4. Die Dicke der Grenzschicht beträgt eine Monolage. Die Grenzschicht 4 ist in diesem Ausführungsbeispiel im Wesentlichen parallel zur Wachstumsrichtung der Halbleiterschichten 10 beziehungsweise des optisch aktiven Bereichs 2 ausgerichtet. Auf der Grenzschicht 4 ist eine Passivierungsschicht 5 mit einer Dicke von zirka 20 nm aufgebracht. Grenzschicht 4 und Passivierungsschicht 5 bedecken jeweils die gesamte durch die Facette 3 gebildete Grenzfläche. Auf der der Facette 3 abgewandten Seite der Passivierungsschicht 5 ist eine dielektrische Schichtenfolge 6 aufgebracht, die als Bragg-Spiegel ausgestaltet ist. Der Bragg-Spiegel besteht aus einer Schichtenfolge mit jeweils abwechselnd hohem und niedrigem Brechungsindex. Die elektrische Schicht kann zum Beispiel auf Zinkselenid, Aluminiumoxid, Siliziumdioxid, Tantaloxid oder Silizium basieren. Die Passivierungsschicht 5 kann auch einen Teil des Bragg-Spiegels darstellen. Zusammen mit einem nicht gezeichneten zweiten Bragg-Spiegel an der der Facette 3 gegenüberliegenden, ebenfalls nicht gezeichneten Grenzfläche, bildet der erste Bragg-Spiegel 6 einen Resonator aus, beispielsweise für einen im nahinfraroten emittierenden Halbleiterlaser.

Das optoelektronische Halbleiterbauteil 1 in Form eines Laserstapels kann dann, wie in Figur 3b gezeigt, aus einer Vielzahl gestapelter beziehungsweise gestackter Laserbarren 7 gebildet werden. Je nach konkreter Ausgestaltung der Laserbarren 7 kann es von Vorteil sein, dass eine durchgehende Grenzschicht 4 beziehungsweise Passivierungsschicht 5 über die gesamten Facetten 3 der verschiedenen Laserbarren 7 ausgebildet wird.

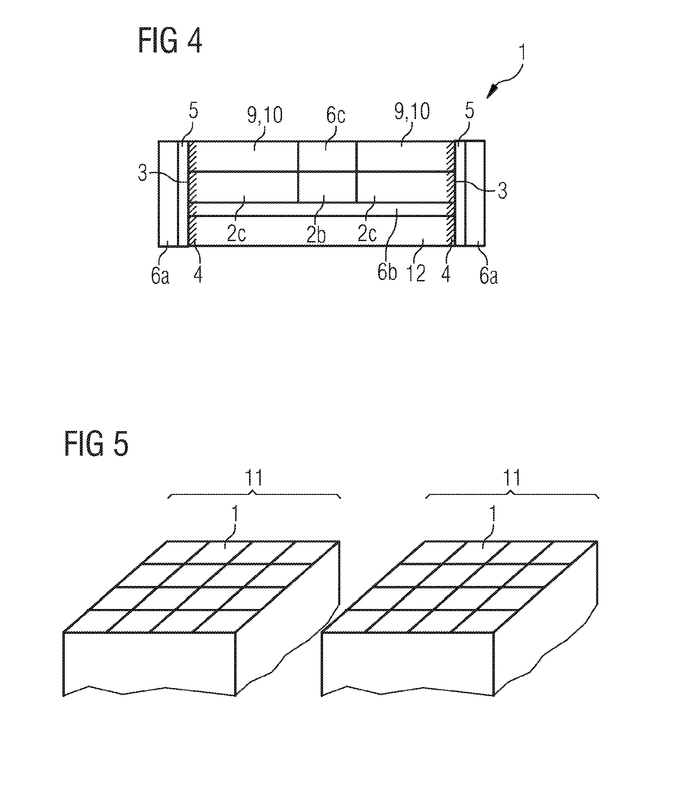

Gemäß Figur 4 wird das optoelektronische Halbleiterbauelement 1 durch einen vertikal emittierenden, beispielsweise optisch gepumpten Halbleiterlaser, kurz VECSEL, gebildet. Auf einem etwa mit einem Halbleitermaterial gebildeten Substrat 12 ist eine erste dielektrische Schichtenfolge 6b, die einen ersten Bragg-Spiegel 6b bildet, aufgebracht. Optisch aktive Bereiche 2b und 2c sind auf der dem Substrat 12 abgewandten Seite eines ersten Bragg-Spiegels 6b angeordnet. Auf der dem Substrat 12 abgewandten Seite der optisch aktiven Bereiche 2c sind Elektroden 9 und Halbleiterschichten 10 angebracht, über die die aktiven Bereiche 2c elektrisch gepumpt werden können und hierdurch einen ersten Laser ausbilden, dessen Resonator durch zwei zweite Bragg-Spiegel 6a gebildet wird. Die zweiten Bragg-Spiegel 6a sind als am weitesten außen liegende Komponenten über den Facetten 3 angebracht. Die Facetten 3 stellen die lateral äußeren Grenzflächen der optisch aktiven Bereiche 2c, des Substrats 12 sowie der Halbleiterschichten 10 dar. An den Facetten 3 des ersten elektrisch gepumpten Lasers sind Grenzschichten 4 angebracht. Die Grenzschichten 4 sind wiederum von Passivierungsschichten 5 abgedeckt, wobei Grenzschichten 4 und Passivierungsschichten 5 die gesamten durch die Facetten 3 gebildeten Grenzflächen abdecken. Grenzschichten 4 und Passivierungsschichten 5 schützen also nicht nur die optisch aktiven Bereiche 2c, sondern auch das diese umgebende Halbleitermaterial.

Der vertikal emittierende, durch den ersten Laser gepumpte optisch aktive Bereich 2b wird von einem dritten Bragg-Spiegel 6c abgedeckt, der zusammen mit dem ersten Bragg-Spiegel 6b den Resonator des VECSEL ausbildet.

Neben horizontal emittierenden Lasern, wie in Figur 3 gezeigt, oder vertikal emittierenden Lasern, wie in Figur 4 dargestellt, können schwefel- oder selenhaltige Grenzschichten ebenfalls in Leuchtdioden und Superlumineszenzdioden Verwendung finden. Auch andere Bauteile, bei denen hohe Lichtintensitäten an Grenzflächen auftreten und die über mindestens ein Halbleitermaterial verfügen, das mindestens einen der Stoffe Gallium oder Aluminium beinhaltet, können mit der beschriebenen Art eines Oxidationsschutzes und/oder einer Passivierung ausgestattet sein.

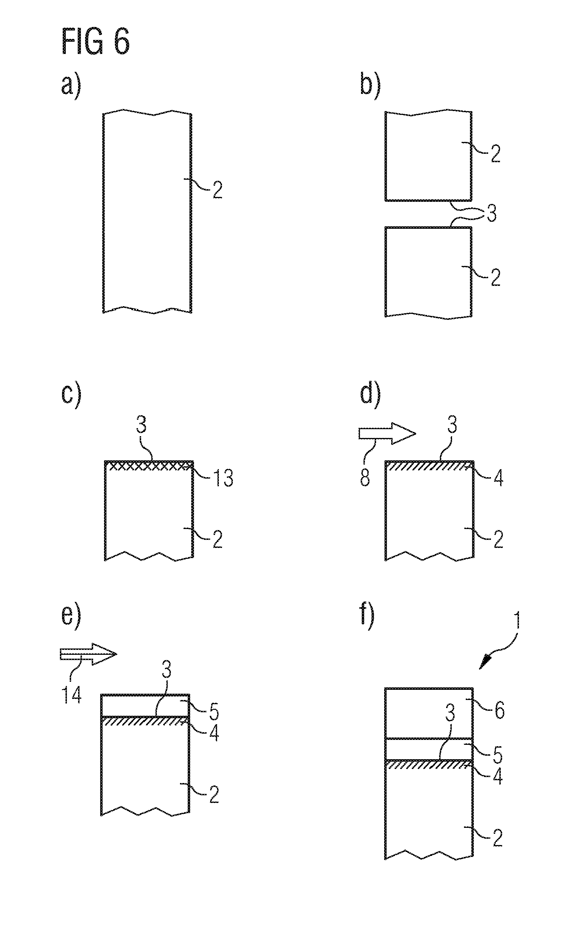

Ein Verfahren zur Herstellung eines optoelektronischen Bauelements 1 ist schematisch in Figur 6 dargestellt.

In Figur 6a wird ein optisch aktiver Bereich 2 bereitgestellt. Der optisch aktive Bereich 2 kann eine Schicht mit Quantenpunkten, Quantentöpfen oder Quantenlinien sein, oder auch einen oder mehrere flächig ausgeprägten pn-Übergangsbereiche beinhalten. Der optisch aktive Bereich 2 kann auch durch Heterostrukturen gebildet sein. Insbesondere kann das Bereitstellen des optisch aktiven Bereichs 2 durch epitaktisches Aufwachsen auf einem Substrat, wie einem Wafer, erfolgen.

In Figur 6b ist das Fertigen der Facetten 3 schematisch dargestellt. Beispielsweise als Wafer vorliegende optisch aktive Bereiche 2 werden angeritzt und anschließend gebrochen, so dass glatte Grenzflächen, die Facetten 3 bilden, entstehen. Um den Aufwand für das Erstellen der Facetten 3 gering zu halten und eine einfache Handhabung zu ermöglichen, werden die Facetten 3 bevorzugt an Luft erstellt.

Da das den optisch aktiven Bereich 2 bildende Halbleitermaterial beispielsweise auf Galliumarsenid, Galliumphosphid oder Galliumnitrid basiert, bildet sich an Luft eine Oxidschicht 13 auf der Facette 3 aus. Diese Oxidschicht und eventuelle weitere Verunreinigungen bilden lokal absorbierende Strukturen aus, die zu einer späteren Zerstörung des optoelektronischen Halbleiterbauelements 1 führen können. Daher ist die Oxidschicht 13, die Galliumoxid und/oder Aluminiumoxid aufweisen kann, zu entfernen, um eine hohe Lebensdauer des Halbleiterbauelements 1 zu gewährleisten.

Dies geschieht, wie in Figur 6d gezeigt, bevorzugt mit einem hoch reaktiven selen- oder schwefelhaltigen Gasfluss 8. Bevorzugt wird der Gasstrom 8 durch H₂Se gebildet. Der sich in der Oxidschicht 13 befindliche Sauerstoff wird hierdurch im Wesentlichen durch Selen substituiert und es bildet sich eine selenhaltige Grenzschicht 4 an der Facette 3 aus. Die Prozesstemperatur während dieses Verfahrensschrittes liegt bevorzugt zwischen 260 und 300° C. Bei diesen Temperaturen erfolgt keine Schädigung, beispielsweise des zur Verwendung in einer Laserdiode ausgestalteten optisch aktiven Bereichs 2. Der Atmosphärendruck während der Desoxidation beträgt einige hundert mbar. Es ist somit keine aufwändige und dadurch kostenintensive Hochvakuum- oder Ultrahochvakuumumgebung erforderlich. Bei den beschriebenen Prozessbedingungen beträgt die Dauer der Oxidation weniger als eine Minute.

Nach der Desoxidation mittels des Gasstroms 8 wird ohne Pause schnell auf einen weiteren Gasstrom 14 umgeschaltet, über den die Passivierungsschicht 5 aufgetragen wird. Besteht die Passivierungsschicht 5 aus Zinkselenid, so besteht der Gasstrom 14 etwa aus einer Mischung aus einem selen- und einem zinkhaltigen Gas, beispielsweise aus H₂Se und Trimethylzink. Erneut findet dieser Prozess wieder bei Drücken von einigen hundert mbar statt. Dieser Verfahrensschritt findet bevorzugt in derselben Prozessführungskammer wie die Desoxidation statt, sodass kein Umlagern der zu passivierenden Bauteile erforderlich ist.

Die exakte Stöchiometrie und die Dicke der Passivierungsschicht 5 richten sich nach den jeweiligen Erfordernissen. Bevorzugt beträgt die Dicke etwa 50 nm. Die Aufwachsgeschwindigkeit der Zinkselenidschicht liegt bei einigen hundert Nanometern pro Minute, so dass auch der Verfahrensschritt des Aufwachsens der Passivierungsschicht 5 auf der Sekunden-Zeitskala ablaufen kann und somit nur wenig Zeit in Anspruch nimmt.

Die Verfahrensschritte Desoxidation gemäß Figur 6d und Aufwachsen der Passivierungsschicht 5 gemäß Figur 6e laufen bevorzugt bei in einer Horde 11 eingehordeten optisch aktiven Bereichen 2 ab, wie in Figur 5 illustriert. Die beispielsweise quaderförmige Geometrien aufweisenden eingehordeten optoelektronischen Halbleiterbauelemente 1 werden aneinander geschichtet, so dass die zu desoxidierenden beziehungsweise zu beschichtenden Facetten 3 etwa in einer Ebene und parallel zueinander ausgerichtet sind. Die nicht durch die Facette 3 gebildeten Seitenflächen der Bauelemente 1 sind bevorzugt so angeordnet, dass sie sich gegenseitig, mindestens zum Teil, berühren und somit keine Beschichtung oder auch Kontamination der nicht durch die Facette 3 gebildeten Seitenflächen stattfindet. Je nach Erfordernissen können auch mehrere derartige gebildete Horden 11 auf einem nicht gezeichneten Träger angebracht sein.

Die Facetten 3 weisen zum Beispiel Flächen in der Größenordnung eines Quadratmillimeters auf. Bei einem angenommenen Trägerdurchmesser von zirka 100 mm können so in einer Charge zirka 1000 einzelne Halbleiterelemente 1 einfach gehandhabt werden. Nach Desoxidation und Passivierung der Facetten 3 können die Horden 11 aus der Prozessführungskammer entfernt und beispielsweise gewendet werden, sodass die den gezeigten Facetten 3 gegenüberliegenden Facetten, sofern erforderlich, ebenfalls behandelt werden können. Da besagte Verfahrensschritte keine Vakuumbedingungen erfordern, ist die Handhabung erheblich vereinfacht. Bei genannten zu behandelnden Flächen sind Gasströme 8, 14 der Reaktionsgase mit Durchflussgeschwindigkeiten von lediglich zirka 30 µmol/min erforderlich. Der Materialaufwand ist dadurch vergleichsweise gering. Das Verfahren ist leicht für größere Stückzahlen skalierbar.

In einem weiteren, optionalen Verfahrensschritt gemäß Figur 6f kann eine dielektrische Schichtenfolge 6 etwa mittels MOVPE, aufgebracht werden.

Mittels dieses Verfahrens können beispielsweise Bauteile, wie in den Figuren 1 bis 4 gezeigt, erzeugt werden.

Ein alternatives Verfahren, eine Facette 3 vor Oxidation zu schützen, besteht darin, die Facette 3 in einem Ultrahochvakuum, kurz UHV, etwa durch Brechen zu erzeugen und ebenfalls unter UHV-Bedingungen zu passivieren. Allerdings ist das Erzeugen von Facetten 3 im UHV aufwändig. Bei Drücken von typisch weniger als 10⁻⁸ mbar wird zudem eine Oxidation an der Facette 3 nicht vollständig verhindert, sondern nur deutlich verringert. Die Gefahr eines COD besteht grundsätzlich weiterhin.

Eine weitere alternative Möglichkeit ist dadurch gegeben, dass Facetten 3 an Luft erzeugt und anschließend im UHV weiterbehandelt werden. Die Facetten 3 können beispielsweise mittels eines H₂-Plasmas unter UHV-Bedingungen gereinigt werden. Auch bei dieser Methode verbleiben Restoxide an den Facetten 3. Zudem ist UHV-Technologie kostenintensiv und nur bedingt für größere zu behandelnde Flächen beziehungsweise Stückzahlen skalierbar.

Die hier beschriebene Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet. Dies gilt auch, wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 10 2008 018 928.6, deren Offenbarungsgehalt hiermit durch Rückbezug aufgenommen wird.

## Patentansprüche

1. Optoelektronisches Halbleiterbauelement (1) mit
- mindestens einem optisch aktiven Bereich (2) mit einem mindestens einen der Stoffe Gallium oder Aluminium enthaltenden kristallinen Halbleitermaterial,
- mindestens einer Facette (3) am optisch aktiven Bereich (2), und
- mindestens einer Schwefel- oder Selen-haltigen Grenzschicht (4) aus bis zu 10 Monolagen an der Facette (3).

2. Optoelektronisches Halbleiterbauelement (1) nach Anspruch 1,
das mindestens eine Passivierungsschicht (5) auf der Grenzschicht (4) umfasst.

3. Optoelektronisches Halbleiterbauelement (1) nach Anspruch 1 oder 2,
bei dem die Grenzschicht (4) GaSe, GaS, AlSe oder AlS aufweist.

4. Optoelektronisches Halbleiterbauelement (1) nach einem der vorhergehenden Ansprüche,
bei dem die Passivierungsschicht (5) mit ZnSe oder ZnS gestaltet ist.

5. Optoelektronisches Halbleiterbauelement (1) nach einem der vorhergehenden Ansprüche,
bei dem die Dicke der Passivierungsschicht (5) wenigstens 5 nm und höchstens 200 nm beträgt.

6. Optoelektronisches Halbleiterbauelement (1) nach einem der vorhergehenden Ansprüche,
das mindestens eine dielektrische Schichtenfolge (6) in Form eines Bragg-Spiegels auf der Passivierungsschicht (5) aufweist.

7. Optoelektronisches Halbleiterbauelement (1) nach einem der vorhergehenden Ansprüche,
das als Laserbarren (7) ausgestaltet ist.

8. Verfahren zur Herstellung eines optoelektronischen Halbleiterbauelements (1) mit den Schritten
- Bereitstellen eines optisch aktiven Bereichs (2), dessen Halbleitermaterial mindestens einen der Stoffe Gallium oder Aluminium enthält,
- Erzeugen mindestens einer Facette (3) am optisch aktiven Bereich (2),
- Desoxidation der Facette (3) mittels eines Schwefel-oder Selen-haltigen Gasstroms (8), und
- Erzeugen einer Schwefel- oder Selen-haltigen Grenzschicht (4) aus bis zu 10 Monolagen.

9. Verfahren nach Anspruch 8,
wobei auf der Grenzschicht (4) mindestens eine Passivierungsschicht (5) mittels eines Gasstroms (14) aufgebracht wird.

10. Verfahren nach Anspruch 8 oder 9,
wobei der Atmosphärendruck mindestens bei den Schritten Desoxidation und Erzeugen der Grenzschicht (4) größer ist als 10⁻³ mbar.

11. Verfahren nach Anspruch 9 oder 10,
wobei die Verfahrensschritte Desoxidation und Aufbringen der Passivierungsschicht (5) in derselben Verfahrensführungskammer stattfinden.

12. Verfahren nach einem Ansprüche 8 bis 11,
wobei der Gasstrom (8, 14) zur Desoxidation oder zum Aufbringen der Passivierungsschicht (5) mindestens einen der folgenden Stoffe enthält: H₂, H₂Se, H₂S, ein Se-Metallorganyl, ein S-Metallorganyl, Trimethyl-Zn, Diethyl-Zn, ein Zn-Organyl.

13. Verfahren nach einem der Ansprüche 8 bis 12,
wobei die Verfahrenstemperatur unterhalb von höchstens 360° C liegt.

14. Verfahren nach einem der Ansprüche 8 bis 13,
wobei die Dauer für die Verfahrensschritte Desoxidation und/oder Aufbringen der Passivierungsschicht (5) weniger als 6 min beträgt.

15. Verfahren nach einem der Ansprüche 8 bis 14,
wobei mindestens bei den Verfahrensschritten Desoxidation und/oder Aufbringen der Passivierungsschicht (5) die Halbleiterbauelemente in einer Horde (11) eingehordet sind.
